Europäisches Patentamt

European Patent Office

Office européen des brevets

(19)

(11) Veröffentlichungsnummer : **0 154 129**
**B1**

(12) **EUROPÄISCHE PATENTSCHRIFT**

(45) Veröffentlichungstag der Patentschrift :
**16.06.87**

(51) Int. Cl.⁴ : **G 01 R 33/02**

(21) Anmeldenummer : **85100482.0**

(22) Anmeldetag : **18.01.85**

(54) **Magnetisches Sondentripel.**

(30) Priorität : **08.02.84 DE 3404375**

(43) Veröffentlichungstag der Anmeldung :
**11.09.85 Patentblatt 85/37**

(45) Bekanntmachung des Hinweises auf die Patenterteilung : **16.06.87 Patentblatt 87/25**

(84) Benannte Vertragsstaaten :
**DE FR GB IT**

(56) Entgegenhaltungen :
**DE-A- 2 206 856**
**US-A- 4 194 150**
**SOVIET INVENTIONS ILLUSTRATED, Sektion EL,**
**Woche C 44, 10. Dezember 1980, DERWENT PUBLICA-**
**TIONS LTD., London, Seiten 31,32**

(73) Patentinhaber : **Institut Dr. Friedrich Förster Prüfgerä-**
**tebau GmbH & Co. KG**
**Postfach 925 In Laisen 70**
**D-7410 Reutlingen 1 (DE)**

(72) Erfinder : **Sy, Gerhard**
**Joh.-Seb.-Bach-Strasse 79**
**D-7410 Reutlingen (DE)**

**Beschreibung**

Die Erfindung betrifft ein magnetisches Sondentripel mit drei aufeinander senkrecht stehenden Hauptachsen zum Messen eines magnetischen Totalfeldes oder der Projektionen eines Magnetfeldes bzw. einer Magnetfelddifferenz in die Richtung der drei Hauptachsen, bestehend aus jeweils zwei zu den Richtungen der Hauptachsen parallellaufenden, gleich aufgebauten Teilsonden, wobei die Achsen zweier zusammengehöriger Teilsonden Rechtecke aufspannen, deren Mittelpunkte in einem Punkt zusammenfallen und die aufeinander senkrecht stehen.

Für die Messung von Magnetfelddifferenzen ist in jedem Fall die Benutzung von Teilsonden unerläßlich. Die gesuchte Magnetfelddifferenz erhält man als Differenz der von den beiden Teilsonden an deren Ort ermittelten Magnetfelder. Aber auch bei der Messung von Magnetfeldern ist der Einsatz von zwei Teilsonden gebräuchlich, insbesondere wenn Kernsaturationssonden verwendet werden. Dabei wird jeweils die Summe der Meßergebnisse der beiden Teilsonden gebildet. Unter einem magnetischen Totalfeld $H_T$ versteht man die Wurzel aus der Summe der Quadrate der Komponenten eines Magnetfeldes. Bei kartesischen Koordinaten x, y, z ist demnach

$$H_T = \sqrt{Hx^2 + Hy^2 + Hz^2}$$

mit Hx, Hy, Hz als den Komponenten des Magnetfeldes in den Richtungen der drei Koordinaten. Um zum magnetischen Totalfeld $H_T$ zu gelangen müssen also noch zusätzliche Rechenoperationen ausgeführt werden, wenn die Komponenten des Magnetfeldes vorliegen.

Ein Sondentripel erlaubt die Ermittlung der genannten Größen zumindest näherungsweise für einen bestimmten Raumpunkt. Der Meßwert eines magnetischen Totalfeldes konstanten Betrages ändert sich nicht, wenn das Sondentripel um den Raumpunkt beliebig gedreht wird. Dagegen ergeben sich, wenn nur die Komponenten eines Magnetfeldes bzw. einer Magnetfelddifferenz für einen Raumpunkt gesucht sind, im allgemeinen unterschiedliche Meßwerte für jeden Raumwinkel des Sondentripels gegenüber dem Vektor des Magnetfeldes bzw. der Magnetfelddifferenz. Bei einem Sondentripel der oben beschriebenen Art fallen die Raumpunkte, an denen gemessen wird, nicht nur näherungsweise sondern exakt zusammen. Dies ist aus geometrischen Gründen nur möglich bei aus zwei Teilsonden zusammengesetzten Sondensystemen.

Aus US-PS 4 194 150 ist ein Totalfeldmagnetometer bekannt, das in der eingangs definierten Weise aus drei Systemen mit jeweils zwei Teilsonden aufgebaut ist. Jede der Teilsonden besteht aus einer Induktionsspule sowie einem länglichen Kern hoher magnetischer Permeabilität und geringer Remanenz, der von der Induktionsspule umfaßt wird. Die Induktivität dieser Induktionsspulen bei einem bestimmten Wechselstrom wird als Meßgröße für ein auf den Kern einwirkendes Magnetfeld ausgewertet. Dabei ist die Minderung der Induktivität gegenüber der Induktivität im magnetischen Nullfeld proportional zum Quadrat des entlang der Achse des Kernes wirkenden Magnetfeldes. Wenn, wie vorgesehen ist, alle Induktionsspulen in Serie geschaltet sind, ist die zu ermittelnde Minderung der Gesamtinduktivität proportional der Summe der Quadrate der Feldstärkekomponenten. Damit ergibt sich ein Meßwert, der unmittelbar dem Quadrat des magnetischen Totalfeldes entspricht.

Das in US-PS 4 194 150 beschriebene Totalfeldmagnetometer weist einen wesentlichen Nachteil auf. Es bedarf eines großen Aufwandes an Material und Abgleicharbeit, seine drei Magnetometersysteme wirksam gegeneinander zu entkoppeln. Stehen die Achsen der Systeme nicht exakt senkrecht aufeinander, so ergeben sich gegenseitige Einstreuungen unter den Systemen, die deren quadratische Kennlinie verfälschen. Hierzu heißt es in der Patentschrift, daß trotz engster Toleranzen (einige µm für lineare Abmessungen und Bruchteile einer Minute für Winkel) die Fehler durch mangelnde Ausrichtung der Systeme das Magnetometer für den vorgesehenen Zweck unbrauchbar machen könnten. Der Inhalt der US-Patentschrift und der Gegenstand ihres Schutzrechtes erschöpfen sich darin, umfangreiche Maßnahmen für eine Entkoppelung der Systeme durch sorgfältige Ausrichtung ihrer Achsen zu beschreiben. Zu diesem Zweck muß jede Teilsonde eine aufwendige mechanische Ausrichtvorrichtung aufweisen, die dazu dient, dem Kern jeder einzelnen Teilsonde die gewünschte Ausrichtung gegenüber den anderen fünf Kernen zu geben.

Demgegenüber stellt sich die vorliegende Erfindung die Aufgabe, ein Sondentripel der eingangs definierten Art zu schaffen, bei dem eine wirksame Entkoppelung der drei Sondensysteme auf einfache Art und ohne besonderen Aufwand erreicht wird. Diese Aufgabe wird gelöst durch ein Sondentripel, das gemäß Anspruch 1 gekennzeichnet ist.

Durch die Erfindung wird es möglich, auch wenn relativ hohe Anforderungen gestellt werden, bei entsprechend sorgfältiger Ausführung ganz auf mechanische Ausrichtvorrichtungen zu verzichten. Daß dies eine wesentliche Vereinfachung und Kostenreduzierung für das Sondentripel bedeutet, liegt auf der Hand. Die Möglichkeit hierfür ergibt sich daraus, daß von einem Prinzip abgegangen wird, das beim Sondentripel nach US-PS 4 194 150 Anwendung fand. Das letztere ist so aufgebaut, daß, würde man einen Würfel mit einer Kantenlänge entsprechend dem Abstand zusammengehöriger Teilsonden definieren, die Teilsonden ganz in diesem Würfel verschwinden würden, da die Länge der Teilsonden geringer als die Kantenlänge des Würfels ist. Es kann angenommen werden, daß man die relativ großen Abstände zwischen den Teilsonden bewußt gewählt hat, weil man eine gegenseitige Beeinflussung der Teilsonden befürchtet hat. Im Gegensatz dazu ragen die Teilsonden des erfindungsgemäßen Sondentripels über den oben definierten Würfel weit hinaus. Man kann die Spulen dieser Teilsonden als im mathematischen Sinne näherungsweise unendlich lang gegenüber den Querabmessungen der Teilsonden ansehen, da die Querabmessungen der Teilsonden zwangsläufig höchstens gleich groß sein können wie die Abstände ihrer Achsen. Bei in diesem Sinne unendlich langen Spulen kann man davon ausgehen, daß praktisch alle Feldlinien innerhalb der Spule verlaufen, also seitlich der Spule keine Wirkungen hervorrufen können.

In der Praxis haben sich diese Überlegungen als richtig erwiesen. Es hat sich gezeigt, daß auf diese Weise Sondentripel mit geringer gegenseitiger Beeinflussung möglich sind, ohne daß zusätzlich besondere Maßnahmen ergriffen werden müssen.

Ein weiterer Vorteil des erfindungsgemäßen Sondentripels ist seine Kompaktheit. Wenn, was sich als günstig erwiesen hat, die Teilsonden gegenseitig aneinander anliegen, kann besonders raumsparend und leicht gebaut werden. Vorteilhaft ist darüber hinaus, daß bei solch geringen Abständen der Teilsonden vom geometrischen Mittelpunkt des Sondentripels auch bei sehr inhomogenen Magnetfeldern ein Meßwert ermittelt wird, der dem wirklichen Wert der Feldstärke an diesem Mittelpunkt äußerst nahe kommt. Besonders vorteilhaft wirkt es sich aus, wenn man die Teilsonden mit einem hohen Schlankheitsgrad, etwa größer als 5, ausstattet, wobei als solcher das Verhältnis der Länge L der Teilsonden zu deren Durchmesser d gelten soll. Die gegenseitige Beeinflussung wird umso geringer, je höher man den Schlankheitsgrad macht. Weitere vorteilhafte Ausgestaltungen sind in den Unteransprüchen aufgeführt.

Obgleich die Erfindung sich insbesondere für magnetische Kernsaturationssonden eignet, ist sie grundsätzlich für jede Art von Magnetsonden anwendbar, bei denen die notwendige Mindestschlankheit realisierbar ist.

Im folgenden wird die Erfindung mit Hilfe einiger Figuren und an einem Ausführungsbeispiel näher erläutert. Es zeigen im einzelnen

Figur 1 eine bekannte Anordnung der Teilsonden eines Sondentripels

Figur 2 das erfindungsgemäße Sondentripel

Figur 3 ein Gehäuse für das Sondentripel

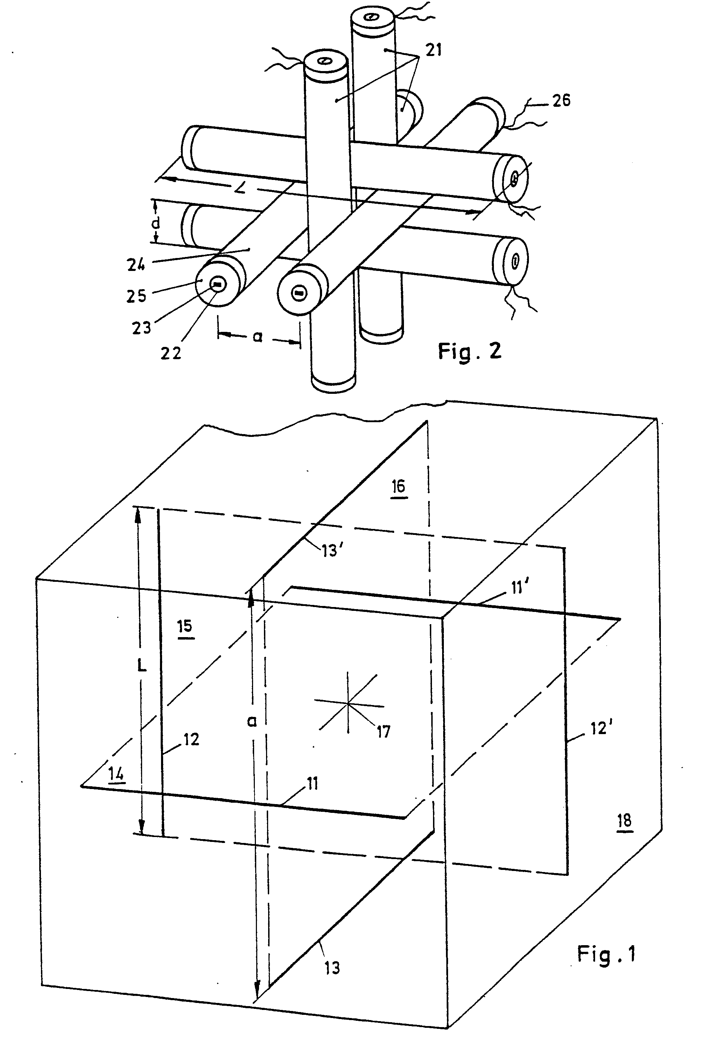

Figur 1 stellt schematisch dar, wie die Teilsonden des Totalfeldmagnetometers nach der oben mehrfach erwähnten US-PS 4 194-150 angeordnet sind. Darin deuten kräftig ausgezogene Stricke die Lage der durchweg gleich aufgebauten Teilsonden 11, 11', 12, 12', 13 und 13' an. Die Teilsondenpaare 11, 11'; 12, 12'; 13, 13' spannen jeweils Ebenen 14, 15, 16 auf, die auf einander senkrecht stehen und deren Mittelpunkte in Punkt 17 zusammenfallen. Auffallend groß ist der Abstand a zwischen den beiden Teilsonden eines Teilsondenpaares. Offenbar wollte man auf diese Weise große Abstände zwischen den Teilsonden verschiedener Teilsondenpaare erzielen, um einer gegenseitigen Beeinflussung entgegen zu wirken. Ein Würfel 18 mit der Kantenlänge a, in dessen Seitenflächen die einzelnen Teilsonden fallen, überdeckt alle Teilsonden, da die Sondenlänge L kleiner ist als der Sondenabstand a.

Figur 2 zeigt ein Sondentripel, bei dem der Erfindungsgedanke realisiert ist. Bei den Teilsonden 21 kann es sich um Kernsaturationssonden bekannter Bauart handeln. Sie sind alle gleich aufgebaut und bestehen aus einem Keramikröhrchen 22 mit einem Schlitz 23, in den (nicht sichtbar) ein streifenförmiger Sondenkern eingebettet ist, einem mit Isoliermitteln abgedeckten Wickel 24, der ein oder mehrere Wicklungen zum magnetischen Sättigen des Sondenkernes und zum Empfang einer Meßspannung enthält und je zwei Endscheiben 25 zum Abgrenzen des Wickelraumes und zum Begründen einer definierten Lage der Teilsonden in Bohrungen eines Sondengehäuses. Die Anschlußleitungen 26 der Teilsonden 21 sind in bekannter Weise mit einer Erreger- und Auswerteelektronik verbunden. Der Abstand a ist so gewählt, daß aufeinander senkrecht stehende Teilsonden 21 sich jeweils berühren, d. h. es gilt a = 2d mit d als Durchmesser der Teilsonden. Die Länge L der Teilsonden 21 beträgt im vorliegenden Beispiel etwa das Vierfache des Abstandes a. Ein Würfel mit der Kantenlänge a würde infolgedessen im Gegensatz zur Anordnung nach Figur 1 von den Teilsonden 21 weit überragt werden.

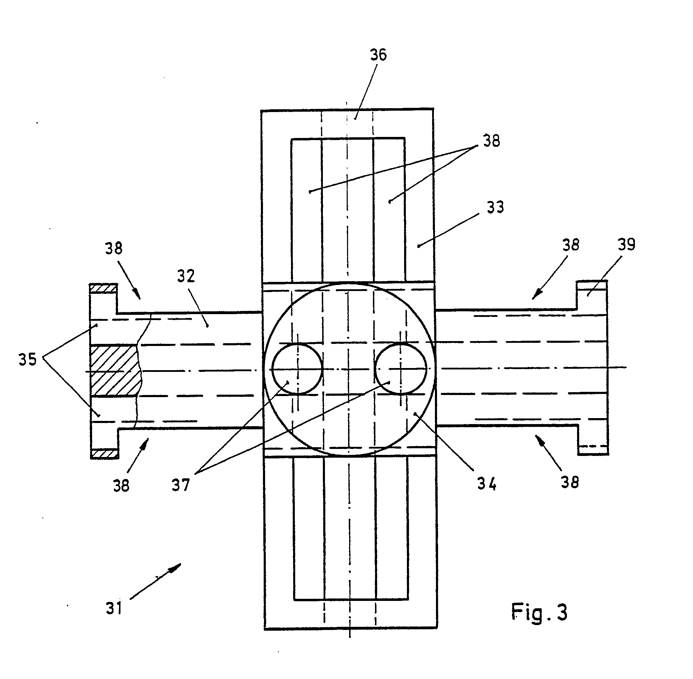

Figur 3 stellt eine Ansicht eines Gehäuses 31 zum Einbau der Teilsonden 21 dar. Das Gehäuse 31 besitzt drei Arme 32, 33, 34, von denen die Arme 32 und 33 senkrecht aufeinander stehend sich in der Zeichenebene erstrecken, Arm 34 dagegen sich senkrecht zur letzteren erstreckt. Da alle drei Arme 32, 33, 34 gleich aufgebaut sind, genügt die dargestellte Ansicht, um eine Vorstellung von dem Gehäuse 31 zu verschaffen. Je zwei durchgehende Bohrungen 35, 36, 37, die zur Aufnahme der Teilsonde 21 vorgesehen sind, verlaufen jeweils in der Richtung der Arme 32, 33, 34 und sind so angeordnet, daß jeweils zwei Bohrungen eines Armes sich zwischen zwei Bohrungen eines anderen Armes befinden. Die axialen Abstände zweier Bohrungen 35, 36, 37 eines Armes 32, 33, 34 sind etwa doppelt so groß wie die Durchmesser der Bohrungen, so daß die Bohrungen Wand an Wand liegen. An Ober- und Unterseite jeden Armes 32, 33, 34 sind beiderseits der gemeinsamen Mitte Einfräsungen 38 angebracht worden, die einerseits dazu dienen einen freien Zugriff zu jeder Teilsonde 24 zu ermöglichen. Die Einfräsungen 38 bieten andererseits die Möglichkeit, auf jeden der Arme 32, 33, 34 zwei jeweils dessen beide Teilsonden 21 umfassende Wicklungen in der Art von Helmholtz-Spulen aufzubringen. Nach außen kann der Wickelraum für diese Wicklungen durch einen stehenbleibenden Ansatz 39 begrenzt werden. Derartige Wicklungen können u. a. dazu dienen, in bekannter Weise ein Rückkopplungs- oder Kompensationsfeld für jeweils zwei Teilsonden aufzubauen. Ebenso ist es auch möglich die Erreger- bzw. Meßwicklungen der Teilsonden zum Aufbau zusätzlicher Felder zu benützen.

### Patentansprüche

1. Magnetisches Sondentripel mit drei aufeinander senkrecht stehenden Hauptachsen zum Messen eines magnetischen Totalfeldes oder der Projektionen eines Magnetfeldes bzw. einer Magnetfelddifferenz in die Richtungen der drei Hauptachsen, bestehend aus jeweils zwei zu den Richtungen der Hauptachsen parallellaufenden, gleich aufgebauten Teilsonden, wobei die Achsen zweier zusammengehöriger Teilsonden Rechtecke aufspannen, deren Mittelpunkte in einem Punkt zusammenfallen und die aufeinander senkrecht stehen, dadurch gekennzeichnet, daß die Länge L der Teilsonden (21) mindestens das 2,5fache des Abstandes a der Achsen zweier zusammengehöriger Teilsonden (21) ist und daß der Abstand a nur geringfügig größer ist als der zweifache Durchmesser d der Teilsonden (21).

2. Sondentripel nach Anspruch 1, dadurch gekennzeichnet, daß zusätzliche Wicklungen über jeweils zwei zusammengehörige Teilsonden (21) in zwei Halbwicklungen nach Art von Helmholtz-Spulen ausgeführt werden, wobei eine Halbwicklung vor und eine Halbwicklung hinter dem Knotenpunkt der Teilsonden (21) angeordnet ist.

### Claims

1. A magnetic probe triplet having three mutually perpendicularly disposed primary axes for measuring a magnetic total field or the projection of a magnetic field or a magnetic field difference in the directions of the three primary axes, comprising two probe members which extend in parallel relationship with the respective directions of each of the primary axes and which are of identical structure, wherein the axes of two associated probe members fix rectangles whose centre points coincide at a point and which are perpendicularly disposed relative to each other, characterised in that the length L of the probe members (21) is at least 2.5 times the spacing a of the axes of two associated probe members (21) and that the spacing a is only slightly larger than double the diameter d of the probe members (21).

2. A probe triplet according to claim 1 characterised in that additional windings over each two associated probe members (21) are formed in two half-windings in the manner of Helmholtz coils, wherein one half-winding is arranged in front of the junction point of the probe members (21) and one half-winding is arranged behind said junction point.

### Revendications

1. Sonde triple magnétique comportant trois axes principaux perpendiculaires les uns aux autres pour la mesure d'un champ magnétique total ou des projections d'un champ magnétique ou d'une différence de champs magnétiques dans les directions des trois axes principaux, constituée par deux sondes partielles orientées parallèlement aux axes principaux et ayant la même structure, les axes de deux sondes associées déterminant des rectangles dont les milieux coïncident en un point et qui sont perpendiculaires l'un à l'autre, caractérisée en ce que la longueur L des sondes partielles (21) est au moins égale à 2,5 fois la distance a entre les axes de deux sondes partielles associées et en ce que la distance a n'est que légèrement supérieure au double du diamètre d des sondes partielles (21).

2. Sonde triple magnétique selon la revendication 1, caractérisée en ce que des enroulements supplémentaires sont placés sur deux sondes partielles associées (21) en deux demi-enroulements du type de bobines de Helmholtz, un demi-enroulement se trouvant en avant du point de nœud des sondes partielles (21) et un demi-enroulement se trouvant en arrière de ce même point.

0 154 129

Fig. 2

Fig. 1

Fig. 3